# FASCICULE DE BREVET EUROPEEN

(11) **EP 2 541 601 B1**
(45) Date de publication et mention de la délivrance du brevet: **08.08.2018**
(21) Numéro de dépôt: 12173327.3
(22) Date de dépôt: 25.06.2012
(51) Int. Cl.: H01L 27/146, H01L 31/0296, H01L 31/18

(54) **Procédé pour la réalisation d'un détecteur de rayonnement électro-magnétique**
Herstellungsverfahren eines Detektors für elektromagnetische Strahlung
Method for producing an electromagnetic radiation detector

(30) Priorité: 30.06.2011 FR 1102031
(43) Date de publication de la demande: 02.01.2013
(73) Titulaire: SOCIETE FRANCAISE DE DETECTEURS, INFRAROUGES- SOFRADIR, F-92290 Chatenay Malabry (FR); Centre National de la Recherche Scientifique, 75016 Paris (FR)
(72) Inventeur: Pautet, Christophe, 38080 Saint Marcel Bel Accueil (FR); Etcheberry, Arnaud, 92700 Colombes (FR); Causier, Alexandre, 27270 Ferrières Saint Hilaire (FR); Gerard, Isabelle, 91190 Gif Sur Yvette (FR)
(74) Mandataire: Cabinet Laurent & Charras

(56) Documents cités:
- US-A- 4 783 594
- US-A- 5 751 049
- IVANITSÂ KA V G ET AL: "Chemical Polishing of CdTe and CdZnTe in Iodineâ Methanol Etching Solutions", JOURNAL OF ELECTRONIC MATERIALS, SPRINGER US, BOSTON, vol. 40, no. 8, 6 mai 2011 (2011-05-06), pages 1802-1808, XP019921485, ISSN: 1543-186X, DOI: 10.1007/S11664-011-1649-2
- LEECH P W ET AL: "A selective etchant for Hg1-xCdxTe, CdTe and HgTe on GaAs", APPLIED SURFACE SCIENCE, ELSEVIER, AMSTERDAM, NL, vol. 37, no. 3, 1 July 1989 (1989-07-01), pages 291-298, XP024656048, ISSN: 0169-4332, DOI: 10.1016/0169-4332(89)90491-1 [retrieved on 1989-07-01]

## Description

### DOMAINE DE L'INVENTION

L'invention appartient au domaine des détecteurs de rayonnements électromagnétiques, et plus particulièrement à un procédé de réalisation d'un tel détecteur.

Un domaine spectral plus particulièrement concerné par l'invention est celui de l'infrarouge, notamment le proche infrarouge, ainsi que le domaine visible.

Les détecteurs de rayonnements électromagnétiques sont classiquement constitués d'un circuit électronique de détection des ondes électromagnétiques à détecter, et donc sensibles à la gamme de longueurs d'ondes correspondantes, transformant de manière connue un rayonnement électromagnétique en un signal électrique. Ce circuit de détection est associé à un circuit électronique de lecture destiné à transformer les signaux électriques générés par le circuit de détection, notamment en les amplifiant pour les rendre susceptibles de subir un traitement ultérieur.

L'invention est plus spécifiquement dirigée vers les détecteurs constitués d'un circuit de détection hybridé à un circuit de lecture, typiquement réalisé en silicium, par la technologie bien connue « *Flip chip* », mettant en oeuvre des billes ou micro-billes d'hybridation, et détectant le rayonnement en question par la face arrière.

Parmi les détecteurs considérés, figurent ceux dont le circuit de détection est réalisé à base d'un alliage répondant à la formule générique HgCdTe, matériau bien connu pour absorber le rayonnement électromagnétique situé dans l'infrarouge. Ce matériau est classiquement obtenu par épitaxie en phase liquide ou gazeuse ou encore par épitaxie par jet moléculaire sur la base d'un substrat réalisé en un alliage CdZnTe massif, ou alternativement, sur un substrat semi-conducteur du type Si, Ge ou AsGa sur lequel a préalablement été déposé une couche d'adaptation du paramètre de maille à base de CdTe ou encore de CdZnSeTe. Dans la suite du texte, et sauf spécifié autrement, ce substrat, qu'il soit en CdZnTe massif ou en semi-conducteur revêtu d'une couche de CdTe ou de CdZnSeTe sera identifié par la formule générique Cd(Zn)Te.

Ce substrat Cd(Zn)Te présente une épaisseur susceptible de varier, typiquement entre 200 et 800 micromètres. Il est peu absorbant au rayonnement à détecter, notamment à l'infrarouge. En revanche, il pose davantage problème lorsque l'on souhaite que le détecteur soit sensible au proche infrarouge ou au domaine du visible.

En effet, le substrat Cd(Zn)Te absorbe le rayonnement incident dans les gammes de longueurs d'onde du proche infra rouge ou du visible, de sorte que le signal détecté s'en trouve réduit et en tout cas n'est pas satisfaisant pour les besoins recherchés.

Le même problème se pose dans le domaine de l'astronomie pour les mêmes raisons puisque le rayonnement cosmique est également absorbé par un tel substrat Cd(Zn)Te et est ensuite réémis dans des longueurs d'ondes pour lesquelles le matériau absorbant en HgCdTe devient sensible, ce qui conduit à la genèse d'images fantômes indésirables.

Afin de s'affranchir de ces difficultés, il convient donc de pouvoir éliminer le substrat de croissance Cd(Zn)Te après hybridation du circuit de détection sur le circuit de lecture.

A cet effet, l'un des procédés connus consiste, après l'étape d'hybridation du circuit de détection sur le circuit de lecture, à procéder à une étape de polissage mécanique ou mécano chimique du substrat Cd(Zn)Te, afin de l'amener de son épaisseur nominale de quelques centaines de micromètres à une épaisseur de quelques dizaines de micromètres typiquement entre 5 et 80 micromètres.

Cette étape de polissage peut être poursuivie ou remplacée par une étape de gravure chimique avec des solutions attaquant sélectivement le CdZnTe par rapport au HgCdTe. La sélectivité de l'attaque par les solutions chimiques entre le CdZnTe et le HgCdTe repose sur le différentiel de composition en mercure et cadmium entre les deux matériaux au niveau de leur interface.

Cette sélectivité se dégrade lorsque la composition du matériau se rapproche de celle du substrat CdZnTe.

L'expérience démontre que la limite de composition pour laquelle la sélectivité de gravure chimique entre le matériau CdZnTe et le matériau HgCdTe reste exploitable se situe pour une composition atomique en cadmium de x = 0.5, le matériau HgCdTe répondant à la formule Hg_{(1 - x)}CdₓTe.

La transition en composition entre le substrat CdZnTe et le matériau Hg_{(1 - x)}CdₓTe est graduelle. En effet, lors de la croissance par épitaxie de la couche de détection en alliage Hg_{(1 - x)}CdₓTe sur le substrat Cd(Zn)Te, un gradient de composition du cadmium entre la couche active Hg_{(1 - x)}CdₓTe et le substrat est créé, résultant :
▪ soit de l'interdiffusion entre l'épitaxie Hg_{(1 - x)}CdₓTe et le substrat CdZnTe dans le cadre de l'épitaxie en phase liquide ;
▪ soit de l'ajustement continu des paramètres de croissance en épitaxie par jet moléculaire ou en épitaxie en phase vapeur.

Le caractère graduel de la transition entre le substrat et le matériau absorbant associé à la sélectivité insuffisante de la gravure chimique impliquent donc qu'une partie du gradient de composition généré lors de l'épitaxie disparaît lors de la gravure chimique du substrat CdZnTe.

Le procédé traditionnel d'élimination du substrat CdZnTe par voie mécanique ou mécano chimique, puis par attaque chimique permet d'obtenir des détecteurs parfaitement fonctionnels avec des rendements de fabrication maîtrisés pour des compositions de matériaux photosensibles Hg_{(1 - x)}CdₓTe riches en mercure, c'est-à-dire avec x_{cd} < 0.4.

Dans les longueurs d'ondes du domaine du visible, le coefficient d'absorption du matériau Hg_{(1 - x)}CdₓTe est de l'ordre de quelques 10⁴ à 10⁵ cm⁻¹ : en d'autres termes, l'essentiel du rayonnement d'intérêt est absorbé très rapidement (quelques centaines de nanomètres).

L'absorption d'un photon près de la face arrière de la couche en matériau détecteur Hg_{(1 - x)}CdₓTe crée une paire d'électron - trou (photo-porteurs).

Dans le cas du Hg_{(1 - x)}CdₓTe riche en mercure, le gradient de composition résiduel en cadmium et les gradients de potentiel des bandes de conduction et de valence associées sont suffisants pour éloigner les photo-porteurs de la face arrière sans qu'ils ne se recombinent sur les centres recombinant localisés en surface (liaisons pendantes non satisfaites, défaut....). Les photo-porteurs peuvent alors diffuser vers la face avant où ils sont collectés par le circuit de lecture.

Dans le cas des compositions de Hg_{(1 - x)}CdₓTe plus faibles en mercure (x_{cd} >0.4), le gradient de composition résiduel et les gradients de potentiels associés deviennent insuffisants pour éloigner les photo-porteurs de la face arrière, de sorte que ceux-ci se recombinent sur les centres recombinant localisés en surface.

Or, la recombinaison des photo-porteurs touche d'autant plus les porteurs photo-générés près de la surface, donc ceux correspondant aux photons de courtes longueurs d'onde pour lesquels le coefficient d'absorption est le plus élevé. On observe alors une perte de sensibilité dans les basses longueurs d'onde, plus ou moins marquée selon les zones du détecteur.

Dit autrement, le gradient de composition résultant de l'épitaxie entre le substrat Cd(Zn)Te et le matériau détecteur HgCdTe génère un gradient de bande interdite qui repousse les photo-porteurs vers la face arrière, de sorte que la fonctionnalité du détecteur n'est pas impactée par d'éventuels centres recombinants localisés à la surface du HgCdTe pour une composition atomique de mercure supérieure à 0.6.

A l'inverse, les procédés d'élimination du substrat de croissance CdZnTe ne sont pas suffisamment sélectifs entre le CdZnTe et le HgCdTe qui engendrent une disparition partielle ou totale du gradient de composition en cadmium (et de manière complémentaire en mercure) généré lors de l'épitaxie, de sorte que les centres recombinants localisés à la surface du HgCdTe entraînent une recombinaison des porteurs photo-générés près de la face arrière, induisant une perte de sensibilité du détecteur dans les basses longueurs d'onde.

L'objectif recherché par la présente invention est de surmonter ces difficultés.

Le document US 4 783 594 décrit (voir les figures 5A - 5J) un procédé pour l'élimination du substrat de croissance (52, CdZnTe, col. 5, lignes 40 - 41) d'un circuit de détection (18, 20, 28) de rayonnement électromagnétique, notamment dans le domaine de l'infrarouge ou du visible, ledit circuit de détection comportant une couche de détection (18, 20) dudit rayonnement réalisée en Hg₁₋ₓCdₓTe (col. 5, lignes 42 - 50) obtenue par épitaxie en phase liquide ou gazeuse ou par épitaxie par jet moléculaire (col. 5 lignes 42 - 50), ledit circuit de détection étant hybridé sur un circuit de lecture (14), ledit procédé consistant à soumettre le substrat de croissance (52) à une étape de polissage mécanique ou mécano chimique ou à une étape d'attaque chimique afin de réduire son épaisseur (col. 6 lignes 40 - 60).

Les documents IVANITS'KA V G ET AL: "Chemical Polishing of CdTe and CdZnTe in Iodine-Methanol Etching Solutions", JOURNAL OF ELECTRONIC MATERIALS, SPRINGER US, BOSTON, vol. 40, no. 8, 6 mai 2011, pages 1802-1808 et LEECH P W ET AL: "A selective etchant for Hg1-xCdxTe, CdTe and HgTe on GaAs", APPLIED SURFACE SCIENCE, ELSEVIER, AMSTERDAM, NL, vol. 37, no. 3, 1 juillet 1989 (1989-07-01), pages 291-298 concernent des procédés de gravure du CdZnTe ou du HgCdTe, HgTe, CdTe.

### BREVE DESCRIPTION DE L'INVENTION

Le procédé selon la présente invention est défini dans la revendication 1. Ainsi, l'invention vise en premier lieu un procédé particulier apte à traiter la face arrière de la couche de détection réalisée en HgCdTe d'un circuit de détection hybridé sur un circuit de lecture, postérieurement aux procédés classiques mécaniques ou mécano chimiques, et/ou alternativement d'attaque chimique, tendant à l'élimination du substrat de croissance CdZnTe, de telle sorte à éliminer les centres recombinants présents sur ladite surface et dès lors, éviter la recombinaison des photo-porteurs avec lesdits centres recombinants.

Ainsi donc l'invention vise un procédé pour éliminer le substrat de croissance CdZnTe d'un circuit de détection de rayonnement électromagnétique, notamment dans le domaine de l'infrarouge ou du visible réalisé en Hg_{(1 - x)}CdₓTe par épitaxie en phase liquide ou gazeuse ou par épitaxie par jet moléculaire, ledit circuit de détection étant hybridé sur un circuit de lecture, puis pour traiter l'interface entre le substrat de croissance et le matériau de détection obtenu consécutivement à l'élimination dudit substrat de croissance.

Ce procédé consiste à soumettre le substrat de croissance à une étape de polissage mécanique ou mécano chimique ou à une attaque chimique afin d'éliminer ledit substrat, puis à soumettre l'ensemble ainsi obtenu à un traitement iodé.

En d'autres termes, l'invention consiste à mettre en oeuvre les procédés traditionnels d'élimination du substrat de croissance, notamment mécanique ou mécano chimique, et ou par attaque chimique, puis, après réalisation de ces étapes classiques, à soumettre l'ensemble à un traitement chimique iodée, notamment par immersion dans un bain de composition appropriée, typiquement dans une solution aqueuse acide de KI/I₂/HBr, ou de HI/I₂.

Ainsi donc, le traitement du composant obtenu après mise en oeuvre des procédés traditionnels de polissage mécanique ou mécano chimique, et ou attaque chimique classique, par une solution aqueuse, par exemple de KI/I₂/HBr, conduit à la formation d'un film de surface très mince d'iode élémentaire, directement ponté sur la surface et stable dans le temps et en température.

Ce film de surface permet d'éliminer, sinon de neutraliser les centres recombinants présents à la surface du matériau absorbant HgCdTe : en d'autres termes, le film d'iode induit la passivation de ladite surface.

Le bain peut également être constitué d'iode moléculaire dissout dans de l'alcool, et notamment I₂ - MeOH.

Il peut être envisagé de soumettre ledit substrat de croissance préalablement à l'attaque chimique iodée en milieu acide, mais postérieurement au traitement de polissage à une gravure chimique afin d'éliminer l'épaisseur résiduelle de CdZnTe.

En tout état de cause, le procédé de l'invention cherche à passiver la face arrière du matériau HgCdTe tout en le gravant le moins possible.

### BREVE DESCRIPTION DES FIGURES

La manière dont l'invention peut être réalisée et les avantages qui en découlent ressortiront mieux de l'exemple qui suit, donné à titre indicatif et non limitatif depuis les figures annexées.

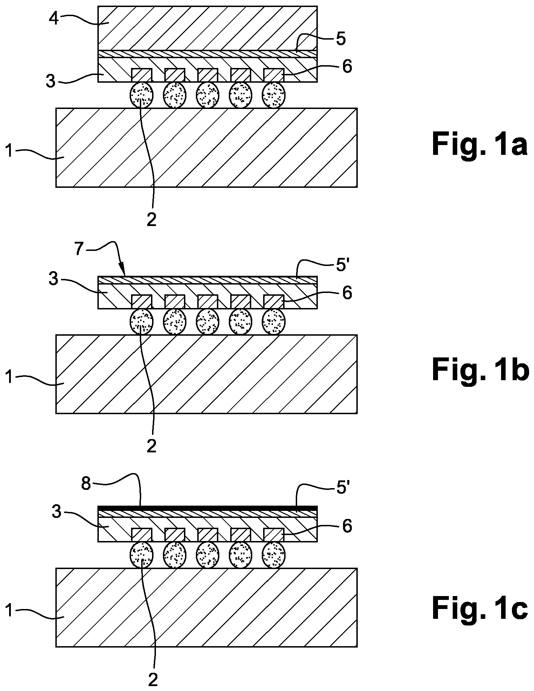

Les figures 1A à 1C sont des représentations schématiques en section d'un détecteur de rayonnements électromagnétiques conforme à l'invention, illustrant les différentes étapes du procédé d'élimination du substrat de croissance CdZnTe du matériau de détection HgCdTe.

### DESCRIPTION DETAILLEE DE L'INVENTION

Le circuit de détection conforme à l'invention est constitué d'une couche **3** d'un alliage de HgCdTe, obtenue par croissance métallurgique sur un support **4** transparent au rayonnement infrarouge. Ce support ou substrat de croissance **4** est, dans l'exemple décrit, réalisé en un alliage de CdZnTe. Il pourrait alternativement être remplacé par un substrat semi-conducteur monocristallin (Si, Ge ou AsGa) sur lequel, préalablement à la phase de croissance, a été déposée une couche d'adaptation du paramètre de maille à base de CdTe, d'une épaisseur de quelques micromètres. Le matériau constitutif de cette couche pourrait par exemple être un alliage quaternaire du type CdSeZnTe.

Cette croissance s'effectue par épitaxie en phase liquide, en phase vapeur, voire par épitaxie par jet moléculaire.

En raison de ce procédé de croissance, il se crée entre la zone absorbante proprement dite **3** et le substrat CdZnTe **4** une zone **5** de variation de composition du cadmium, située en quelque sorte à l'interface entre la zone **3** et le substrat **4.** En d'autres termes, cette zone **5** est située à l'interface entre le substrat de croissance et la zone absorbante **3.**

Dans le cas où la croissance est obtenue par épitaxie en phase liquide, la zone de variation de composition est une zone d'inter-diffusion, qui n'est pas clairement délimitée.

Sur l'autre face de la couche absorbante **3,** c'est-à-dire opposée à la zone de variation de composition **5,** sont réalisées des diodes **6.**

La connexion du circuit de détection, constitué par l'ensemble **3, 4, 5** avec un circuit de lecture **1,** typiquement réalisé par technologie silicium, est obtenue par la technologie bien connue de l'hybridation, au moyen de billes ou microbilles notamment d'indium **2,** et telle que par exemple décrite dans le document FR A 2 646 558.

Ces microbilles **2** assurent à la fois la solidarisation mécanique de l'ensemble de détection au circuit de lecture **1,** mais également la conduction électrique permettant d'assurer le transfert des signaux électriques résultant de l'interaction des rayonnements électromagnétiques avec le circuit de détection au circuit de lecture.

Comme indiqué en préambule, le détecteur de l'invention détecte face arrière, sous-entendu du circuit de la zone de détection **3.** A cet effet, il faut donc éliminer le substrat de croissance **4** en Cd(Zn)Te de ladite couche de détection **3.**

Après donc hybridation du circuit de détection **3, 4, 5** sur le circuit de lecture silicium **1** (figure la), on procède à une première étape de polissage mécano - chimique du substrat Cd(Zn)Te **4.** Ce polissage peut également être remplacé par une étape de rodage mécanique. Cette étape permet de supprimer une grande partie de l'épaisseur du support Cd(Zn)Te, et peut en outre s'accompagner d'une première action chimique à l'aide d'une solution de gravure sélective entre le HgCdTe et le Cd(Zn)Te. Une telle solution est par exemple constituée d'un bain d'acide fluorhydrique, d'acide nitrique et d'acide acétique.

Dans l'hypothèse selon laquelle le substrat de croissance est constitué d'un semi-conducteur monocristallin sur lequel a été déposée une couche de matériau CdTe, la suppression dudit substrat peut être initiée par simple action chimique sélective entre le semi-conducteur considéré et la couche à base de CdTe.

Ce faisant, on aboutit à la vue schématique de la figure 1b dans lequel ne subsiste plus que la zone de variation de composition résiduelle **5',** au contact de la zone en matériau absorbant ou couche de détection **3** en Hg_{(1 - x})CdₓTe. Cette zone est qualifiée de résiduelle, dans la mesure où elle a fait l'objet d'une attaque partielle, soit mécanique, soit chimique lors de l'étape précédente.

A la surface libre **7** de cette zone **5',** on trouve un certain nombre de centres recombinants actifs, qui justement posent problème pour la détection de l'infrarouge proche ou du visible comme exposé en préambule.

On peut soumettre alors l'ensemble constitué par le circuit de détection, hybridé sur le circuit de lecture tout d'abord à une désoxydation de la surface de ladite zone **5'** par immersion dans de l'acide chlorhydrique 1M.

Après rinçage de l'ensemble dans de l'eau désionisée, on soumet alors le même ensemble à une attaque pendant une durée de quelques secondes à quelques minutes ou à quelques dizaines de minutes dans une solution d'attaque iodée, par immersion. Cette solution est typiquement de composition suivante :
▪ iode moléculaire: 10⁻¹ à 10⁻⁵ M ;
▪ acide bromhydrique : HBr de 0,09 M à 9 M ;
▪ eau désionisée.

L'acide bromhydrique peut être remplacée par de l'acide iodhydrique HI, également 0,09 M à 9M, ou par de l'acide chlorhydrique HCl selon même molarité.

Il peut également être envisagé d'introduire dans la solution d'attaque de l'iodure de potassium KI de 8M à 0M, dont la fonction est d'accélérer la dissolution de l'iode I₂ et de stabiliser la solution.

Avec une telle solution, on observe une vitesse d'attaque des couches supérieures de la zone de variation de composition résiduelle **5',** typiquement comprise entre 1 et 6000 nanomètres par minute.

Subséquemment, après rinçage pendant environ cinq minutes dans de l'eau désionisée et séchage à l'azote, on observe la formation d'un film de surface très mince **8** constitué d'iode directement lié chimiquement par liaison covalente à la surface de la zone de variation de composition résiduelle **5',** opposée à la surface hybridée sur le circuit de lecture.

Ce film mince **8** fait fonction de couche de passivation, et inhibe de fait les centres recombinants actifs présents traditionnellement à la surface de la zone de variation de composition résiduelle **5'** résultant des procédés d'amincissement ou d'élimination traditionnels du substrat de croissance CdZnTe.

La formation de ce film d'iode **8** très mince (typiquement une monocouche atomique) à la surface de la zone de variation de composition résiduelle **5'** est observable par notamment la modification des spectres XPS (X-RAY PHOTOELECTRON SPECTROSCOPY) qui fait apparaître un décalage des pics d'énergie du cadmium 3d et du mercure 4f caractéristique de l'établissement de liaisons covalentes entre l'iode et respectivement le cadmium et le mercure constitutifs du matériau de la zone de variation de composition résiduelle **5'.**

Au demeurant, la modification de la surface de ladite couche par attaque en milieu acide est également détectable par ellipsométrie, c'est-à-dire par la technique optique de caractérisation et d'analyse de surface, fondée sur le changement d'état de polarisation de la lumière, par réflexion de la lumière sur la surface plane d'un échantillon. ; cette analyse par ellipsométrie conduit à la modification des indices optiques réels et imaginaires du Hg_{(1 - x)}CdₓTe.

L'exposition du composant ainsi obtenu à des températures élevées, typiquement 10 mn à 145° C, ne modifie pas la surface traitée et montre ainsi la stabilité du réseau iodé de surface **8** dans le temps et en température.

Ce résultat s'avère parfaitement avantageux puisqu'il permet de mettre en oeuvre des traitements thermiques postérieurs à l'élimination de substrats Cd(Zn)Te sans pour autant perdre l'effet bénéfique de passivation de surface par l'iode.

Par voie de conséquence, cela permet d'intégrer le traitement par l'iode dans les enchaînements de procédé technologique entrant dans la fabrication de composés infrarouges, notamment refroidis.

S'agissant des propriétés de détection, l'obtention de cette passivation permet de réduire la vulnérabilité du détecteur à la disparition partielle ou totale du gradient de composition entre le substrat Cd(Zn)Te et la couche active de détection réalisée en matériau Hg_{(1 - x)}CdₓTe lors de l'étape d'attaque chimique sélective. Ce faisant, les photo-porteurs issus des photons de courtes longueurs d'onde, typiquement 400 à 800 nanomètres, qui sont absorbés près de la surface ne se recombinent plus sur la face arrière du circuit de détection, et peuvent dès lors être collectés par le circuit de lecture.

Dans l'exemple mentionné précédemment, on a mis en oeuvre une composition particulière de la solution iodée en milieu acide. On pourrait remplacer l'iodure de potassium par de l'iodate de potassium KIO₃.

L'invention vise également tout procédé dans lequel l'iode moléculaire se forme et/ou est stabilisé, tel que par exemple un système dont le solvant n'est plus l'eau, comme dans l'exemple précédemment décrit, mais un alcool. L'essentiel est de pouvoir disposer dans la solution d'iode moléculaire.

## Revendications

1. Procédé pour l'élimination du substrat de croissance (4) d'un circuit de détection (3, 4, 5) de rayonnement électromagnétique, notamment dans le domaine de l'infrarouge ou du visible, ledit circuit de détection comportant une couche de détection (3) dudit rayonnement réalisée en Hg_{(1 - x)}CdₓTe obtenue par épitaxie en phase liquide ou gazeuse ou par épitaxie par jet moléculaire sur ledit substrat de croissance (4), ledit circuit de détection étant hybridé sur un circuit de lecture (1), ledit procédé consistant :
• à soumettre le substrat de croissance (4) à une étape de polissage mécanique ou mécano chimique ou à une étape d'attaque chimique afin de réduire son épaisseur, jusqu'à aboutir à une zone de variation de composition du cadmium résiduelle (5') au contact de la couche de détection (3);
• puis à soumettre cette zone de variation de composition du cadmium résiduelle (5') ainsi obtenue à un traitement iodé, dans lequel de l'iode est introduit sous forme moléculaire en solution.

2. Procédé pour l'élimination du substrat de croissance (4) d'un circuit de détection (3, 4, 5) de rayonnement électromagnétique selon la revendication 1, ***caractérisé* en ce que** le traitement iodé est réalisé en milieu acide.

3. Procédé pour l'élimination du substrat de croissance (4) d'un circuit de détection (3, 4, 5) de rayonnement électromagnétique selon l'une des revendications 1 et 2, ***caractérisé* en ce que** le traitement iodé s'effectue par immersion du circuit de détection (3, 5') hybridé sur ledit circuit de lecture (1) résultant de l'étape de polissage mécanique ou mécano chimique ou de l'étape d'attaque chimique dans un bain de composition suivante :
▪ iode moléculaire : 10⁻¹ à 10⁻⁵ M ;
▪ acide bromhydrique HBr ou acide iodhydrique HI de 0,09 à 9 M ;
▪ eau désionisée.

4. Procédé pour l'élimination du substrat de croissance (4) d'un circuit de détection (3, 4, 5) de rayonnement électromagnétique selon la revendication 3, ***caractérisé* en ce que** le traitement iodé en milieu acide est précédé d'une action de désoxydation de la surface (7) de la zone de variation de composition du cadmium résiduelle (5') obtenue après l'étape de polissage mécanique ou mécano chimique ou après l'étape d'attaque chimique par soumission de l'ensemble à un bain d'acide chlorhydrique.

5. Procédé pour l'élimination du substrat de croissance (4) d'un circuit de détection (3, 4, 5) de rayonnement électromagnétique selon l'une des revendications 1 et 2, ***caractérisé* en ce que** le traitement iodé s'effectue par immersion du circuit de détection (3, 5') hybridé sur ledit circuit de lecture (1) résultant de l'étape de polissage mécanique ou mécano chimique ou de l'étape d'attaque chimique dans un bain de composition suivante :
▪ iode moléculaire : 10⁻¹ à 10⁻⁵ M ;
▪ acide chlrohydrique HCl de 0,09 à 9 M ;
▪ eau désionisée.

6. Procédé pour l'élimination du substrat de croissance (4) d'un circuit de détection (3, 4, 5) de rayonnement électromagnétique selon la revendication 1, ***caractérisé* en ce que** l'iode est présent sous forme moléculaire en solution et **en ce que** son solvant est constitué par de l'alcool, et notamment I₂ - MeOH.

7. Procédé pour l'élimination du substrat de croissance (4) d'un circuit de détection (3, 4, 5) de rayonnement électromagnétique selon l'une des revendications 1 à 6, ***caractérisé* en ce que** le substrat de croissance est constitué d'un matériau Cd(Zn)Te massif.

8. Procédé pour l'élimination du substrat de croissance (4) d'un circuit de détection (3, 4, 5) de rayonnement électromagnétique selon l'une des revendications 1 à 6, ***caractérisé* en ce que** le substrat de croissance est constitué d'un semi-conducteur monocristallin sur lequel a été préalablement déposée une couche d'adaptation du paramètre de maille à base de CdTe, d'une épaisseur de quelques micromètres.

9. Procédé pour l'élimination du substrat de croissance (4) d'un circuit de détection (3, 4, 5) de rayonnement électromagnétique selon l'une des revendications 1 à 8, ***caractérisé* en ce que** préalablement à la soumission de l'ensemble au traitement iodé, mais postérieurement à l'étape de polissage mécanique ou mécano chimique ou à l'étape d'attaque chimique, ledit circuit de détection (3, 5') hybridé sur ledit circuit de lecture (1) est soumis à une gravure chimique afin d'éliminer l'épaisseur résiduelle du substrat de croissance.

## Patentansprüche

1. Verfahren zum Entfernen eines Wachstumssubstrats (4) von einer Erfassungsschaltung (3, 4, 5) für elektromagnetische Strahlung insbesondere im Infrarot- oder sichtbaren Bereich, wobei diese Erfassungsschaltung eine Strahlungserfassungsschicht, die aus Hg₍₁₋ₓ₎CdₓTe hergestellt wird, die durch Flüssig- oder Gasphasenepitaxie oder durch Molekularstrahlepitaxie auf diesem Wachstumssubstrat (4) erhalten wird, umfasst, wobei diese Erfassungsschaltung auf eine Leseschaltung (1) hybridisiert wird, wobei dieses Verfahren die folgenden Schritte umfasst:
- das Wachstumssubstrat (4) wird einem Schritt des mechanischen oder chemisch-mechanischen Polierens oder des chemischen Ätzens unterzogen, um die Substratdicke zu verringern, bis ein Bereich mit veränderter Zusammensetzung des Restcadmiums (5'), das Kontakt mit der Erfassungsschicht (3) hat, erreicht ist;
- und dieser so erhaltene Bereich mit veränderter Zusammensetzung des Restcadmius (5') wird einer Iodbehandlung unterzogen, bei der das Jod in molekularer Form als Lösung eingeführt wird.

2. Verfahren zum Entfernen eines Wachstumssubstrats (4) von einer Erfassungsschaltung (3, 4, 5) für elektromagnetische Strahlung gemäß Anspruch 1, **dadurch gekennzeichnet, dass** die Jodbehandlung in saurem Milieu erfolgt.

3. Verfahren zum Entfernen eines Wachstumssubstrats (4) von einer Erfassungsschaltung (3, 4, 5) für elektromagnetische Strahlung nach einem der Ansprüche 1 und 2, **dadurch gekennzeichnet, dass** die Jodbehandlung durch Eintauchen der Erfassungsschaltung (3, 5'), die auf dieser Leseschaltung (1) hybridisiert ist, die sich aus dem Schritt des mechanischen oder chemisch-mechanischen Polierens ergibt, in einem Bad mit der folgenden Zusammensetzung geschieht:
▪ molekulares Jod: 10⁻¹ bis 10⁻⁵ M ;
▪ Bromwasserstoffsäure HBr oder Iodwasserstoffsäure HI von 0,09 bis 9 M ;
▪ entionisiertes Wasser.

4. Verfahren zum Entfernen eines Wachstumssubstrats (4) von einer Erfassungsschaltung (3, 4, 5) für elektromagnetische Strahlung gemäß Anspruch 3, **dadurch gekennzeichnet, dass** der Jodbehandlung in saurem Milieu eine Desoxidation der Fläche (7) des Bereichs mit veränderter Zusammensetzung des Restcadmius (5') vorangeht, die sich aus dem Schritt des mechanischen oder chemisch-mechanischen Polierens oder nach dem Schritt des chemischen Ätzens, indem das Bauteil einem Salzsäurebad ausgesetzt wird, ergibt.

5. Verfahren zum Entfernen eines Wachstumssubstrats (4) von einer Erfassungsschaltung (3, 4, 5) für elektromagnetische Strahlung nach einem der Ansprüche 1 und 2, **dadurch gekennzeichnet, dass** die Jodbehandlung durch Eintauchen der Erfassungsschaltung (3, 5') hybridisiert wird, die auf dieser Leseschaltung (1), die sich aus dem Schritt des mechanischen oder chemisch-mechanischen Polierens ergibt, in einem Bad mit der folgenden Zusammensetzung geschieht:
▪ molekulares Jod: 10⁻¹ bis 10⁻⁵ M ;
▪ Salzsäure HCl zwischen 0,09 und 9 M;
▪ entionisiertes Wasser.

6. Verfahren zum Entfernen eines Wachstumssubstrats (4) von einer Erfassungsschaltung (3, 4, 5) für elektromagnetische Strahlung gemäß Anspruch 1, **dadurch gekennzeichnet, dass** das Jod in molekularer Form in Lösung vorhanden ist und dass das Lösungsmittel aus Alkohol, und insbesondere I₂-MeOH besteht.

7. Verfahren zum Entfernen eines Wachstumssubstrats (4) von einer Erfassungsschaltung (3, 4, 5) für elektromagnetische Strahlung nach einem der Ansprüche 1 bis 6, **dadurch gekennzeichnet, dass** das Wachstumssubstrat aus einem massiven Cd(Zn)Te-Material besteht.

8. Verfahren zum Entfernen eines Wachstumssubstrats (4) von einer Erfassungsschaltung (3, 4, 5) für elektromagnetische Strahlung nach einem der Ansprüche 1 und 6, **dadurch gekennzeichnet, dass** das Wachstumssubstrat aus einem monokristallinen Halbleiter besteht, auf dem zuvor eine Anpassungsschicht des Gitterparameters auf CdTe-Basis, in einer Dicke von wenigen Mikrometern abgeschieden wurde.

9. Verfahren zum Entfernen eines Wachstumssubstrats (4) von einer Erfassungsschaltung (3, 4, 5) für elektromagnetische Strahlung nach einem der Ansprüche 1 bis 8, **dadurch gekennzeichnet, dass** vor der Jodbehandlung der Einheit, aber nach dem Schritt des mechanischen oder chemisch-mechanischen Polierens oder der chemischen Ätzung, diese auf dieser Leseschaltung (1), hybridisierte Erfassungsschaltung (3, 5') einer chemischen Gravur ausgesetzt wird, um die restliche Dicke des Wachstumssubstrats zu entfernen.

## Claims

1. A method for removing the growth substrate (4) of a circuit (3, 4, 5) of electromagnetic radiation detection, especially in the infrared or visible range, said detection circuit comprising a layer (3) of detection of said radiation made of Hg₍₁₋ₓ₎CdₓTe obtained by liquid or vapor phase epitaxy or by molecular beam epitaxy, said detection circuit being hybridized on a read circuit (1), said method comprising:
• submitting the growth substrate (4) to a mechanical or chem.-mech. polishing step or to a chemical etch step to decrease its thickness, until an area of composition variation of residual cadmium (5') in contact with the layer of detection (3) is reached;
• and submitting this area of variation of composition of residual cadmium (5') thus obtained to an iodine treatment, in which iodine is introduced in molecular form in solution.

2. The method for removing the growth substrate (4) of an electromagnetic radiation detection circuit (3, 4, 5) of claim 1, ***wherein*** the iodine treatment is carried out in an acid medium.

3. The method for removing the growth substrate (4) of an electromagnetic radiation detection circuit (3, 4, 5) of any of claims 1 and 2, ***wherein*** the iodine treatment is performed by immersion of the detection circuit (3, 5') hybridized with the read circuit (1) resulting from the mechanical and/or chem.-mech. polishing steps and/or from the chemical etching in a bath having the following composition:
▪ molecular iodine: from 10⁻¹ to 10⁻⁵ M;
▪ hydrobromic acid HBr or hydriodic acid HI from 0.09 to 9 M;
▪ deionized water.

4. The method for removing the growth substrate (4) of an electromagnetic radiation detection circuit (3, 4, 5) of claim 3, ***wherein*** the iodine treatment in an acid medium follows an action of deoxidation of the surface (7) of the area of composition variation of residual cadmium (5') obtained after a mechanical and/or chem.-mech. polishing step or a step of chemical etching by submitting the assembly to a hydrochloric acid bath.

5. The method for removing the growth substrate (4) of an electromagnetic radiation detection circuit (3, 4, 5) of any of claims 1 and 2, ***wherein*** the iodine treatment is performed by immersion of the detection circuit (3, 5') hybridized with the read circuit (1) resulting from the mechanical and/or chem.-mech. polishing steps and/or from the chemical etching in a bath having the following composition:
▪ molecular iodine: from 10⁻¹ to 10⁻⁵ M;
▪ hydrochloric acid HCl from 0.09 to 9 M;
▪ deionized water.

6. The method for removing the growth substrate (4) of an electromagnetic radiation detection circuit (3, 4, 5) of claim 1, ***wherein*** iodine is present in molecular form in solution and wherein its solvent is alcohol, and especially I₂ - MeOH.

7. The method for removing the growth substrate (4) of an electromagnetic radiation detection circuit (3, 4, 5) of any of claims 1 to 6, ***wherein*** the growth substrate is formed of a solid Cd(Zn)Te material.

8. The method for removing the growth substrate (4) of an electromagnetic radiation detection circuit (3, 4, 5) of any of claims 1 to 6, ***wherein*** the growth substrate is formed of a single-crystal semiconductor on which a CdTe-based mesh parameter adaptation layer having a thickness of a few micrometers has previously been deposited.

9. The method for removing the growth substrate (4) of an electromagnetic radiation detection circuit (3, 4, 5) of any of claims 1 to 8, ***wherein*** prior to submitting the assembly to the iodine treatment, but subsequently to the mechanical or chem.-mech. polishing step or to the chemical etch step, said detection circuit (3, 5') hybridized with the read circuit (1) is submitted to a chemical etching to remove the residual thickness of the growth substrate.
